# EUROPEAN PATENT SPECIFICATION

(11) **EP 1 808 706 B1**
(45) Date of publication and mention of the grant of the patent: **21.07.2010**
(21) Application number: 07250151.3
(22) Date of filing: 16.01.2007
(51) Int. Cl.: G01R 33/3815, H01F 6/04

(54) **Superconducting magnet apparatus**
Supraleitende Magnetvorrichtung
Appareil à aimant supraconducteur

(30) Priority: 17.01.2006 JP 2006008617
(43) Date of publication of application: 18.07.2007
(73) Proprietor: Hitachi, Ltd., Chiyoda-ku Tokyo 100-8220 (JP)
(72) Inventor: Nemoto, Takeo, Chiyoda-ku Tokyo 100-8220 (JP); Chiba, Tomoo, Chiyoda-ku Tokyo 100-8220 (JP)
(74) Representative: Calderbank, Thomas Roger

(56) References cited:
- EP-A2- 0 937 995
- EP-A2- 0 977 048
- US-A- 5 410 286
- US-A1- 2005 088 266

## Description

The present invention relates to a superconducting magnet apparatus, and more particularly to a superconducting magnet apparatus for MRI (Magnetic Resonance Imaging) equipped with a refrigerator.

A conventional superconducting magnet apparatus is disclosed in, for example, FIG. 5 of Japanese Patent Laid-open Publication No. 2005-55003 (first patent literature). The superconducting magnet apparatus is configured with a superconducting coil, a thermal shield containing liquid helium for cooling the superconducting coil, a vacuum vessel containing the thermal shield, a sleeve from the vacuum vessel to the thermal shield, and a multistage refrigerator which is detachably attached inside the sleeve and has first and second stage cooling cylinders for cooling the thermal shield.

In addition, a conventional cryostat equipped with a refrigerator is disclosed in Japanese Patent No. 2961619 (second patent literature). The conventional cryostat equipped with a refrigerator is configured with a superconducting magnet, a cryogenic container containing liquid helium for cooling the superconducting magnet, a second thermal shield cylinder containing the cryogenic container, a first thermal shield cylinder containing the second thermal shield cylinder, a vacuum vessel containing the first thermal shield cylinder, an airtight bulkhead disposed across a space communicating a first vacuum room within the vacuum vessel and a second vacuum room within the first thermal shield cylinder, and a multistage refrigerator which is detachably attached within the airtight bulkhead and has a first low temperature portion for cooling the first thermal shield cylinder and a second low temperature portion for cooling the second thermal shield cylinder.

In the first and the second patent literatures, a refrigerator which is detachably attached to the apparatus is disclosed. However, a method for maintaining a cooling object (object to be cooled: superconducting coil or superconducting magnet) at a low temperature for a long time when the refrigerator is stopped to operate is not disclosed. In the superconducting magnet apparatus of the first patent literature or the cryostat equipped with a refrigerator of the second patent literature, when the refrigerator is stopped from operating, since the liquid helium in the thermal shield or the cryogenic container evaporates by heat transfer from outside, it becomes necessary to release the evaporated helium gas for avoiding a pressure increase in the thermal shield or the cryogenic container. If the helium gas is simply released, consumption of the helium, which is expensive cryogen, increases remarkably. In addition, since a temperature of the liquid helium increases rapidly by heat transfer from outside, it becomes difficult to cool the cooling object in a short time. Especially, in a case of a superconducting magnet apparatus for MRI used for a clinical diagnostic, it is earnestly desired that the superconducting magnet apparatus does not quench even when the refrigerator is stopped for a given length of time. It is, therefore, an object of the present invention to provide a superconducting magnet apparatus which can easily attach and detach a refrigerator and can save liquid helium consumption even when the refrigerator's operation is stopped, while maintaining a cooling object (object to be cooled) at a low temperature for a long time.

US 5410286 discloses a superconducting magnet surrounding by a gaseous helium assembly having a thermal shield and a cryocooler with a first cooling stage in thermal contact with the thermal shield and a second cooling stage in thermal contact with a magnet cartridge containing the superconducting magnet.

According to the present invention, there is provided superconducting magnet apparatus as set out in claim 1.

More preferable specific configuration of the present invention is as follows.
(1) A concave-tapered surface (a tapered surface which has a diameter becoming larger from a bottom to a top of the tapered surface) is formed on an inner periphery surface of the first heat transfer member and a convex-tapered surface (a tapered surface which has a diameter becoming larger from a bottom to a top of the tapered surface) is formed on an outer periphery surface of the second heat transfer member, and the second heat transfer member is detachably attached to the first heat transfer member by fitting the convex-tapered surface of the second heat transfer member to the concave-tapered surface of the first heat transfer member.
(2) The vacuum vessel is made of stainless steel which has a low thermal conductivity; the refrigerator port is configured with a dissimilar joint and a stretchable bellows; one end of the dissimilar joint is made of one of copper and aluminum which has a high thermal conductivity and is used for the first heat transfer member, and the other end is made of a low thermal conductive material of stainless steel which has a low thermal conductivity; and the low thermal conductive material and the vacuum vessel are jointed by the bellows which is made of stainless steel.
(3) A gas flow path for cooling the second heat transfer member and the first stage by guiding the helium gas, which is evaporated within the cryogenic container, from one end of the refrigerator port when the multistage refrigerator is stopped is formed on an attachment surface of the second heat transfer member for the first stage.
(4) The gas flow path is formed in a spiral groove winding an outer periphery surface of the first stage.
(5) A gas flow path for cooling one of the first heat transfer member and the second heat transfer member by guiding the helium gas, which is evaporated within the cryogenic container, from one end of the refrigerator port when the multistage refrigerator is stopped is formed so that the gas flow path passes through one of the first heat transfer member and the second heat transfer member.
(6) A gas flow path for cooling the second heat transfer member by guiding the helium gas, which is evaporated within the cryogenic container, from one end of the refrigerator port when the multistage refrigerator is stopped is formed in a spiral shape winding around an outer periphery surface of the second heat transfer member.
(7) The helium gas passed through the gas flow path is released into atmosphere through a check valve (one-way valve) after heat-exchanging with the thermal shield and passing through the vacuum vessel.
(8) A porous polymer is arranged in a space formed between the multistage refrigerator and the refrigerator port.
(9) The superconducting coil is a superconducting coil for MRI; the helium contained in the cryogenic container is composed of gas-liquid two phases of helium gas and liquid helium; and the superconducting coil for MRI is dipped in the liquid helium.

According to the present invention, a superconducting magnet apparatus can be provided, which can easily attach and detach a refrigerator and can save liquid helium consumption even when the refrigerator is stopped, while maintaining a cooling object (object to be cooled) at a low temperature for a long time.

IN THE DRAWINGS
FIG. 1 is a cross sectional view of a main part of a superconducting magnet apparatus according to a first embodiment of the present invention;
FIG. 2 is an illustration showing a first stage and a second heat transfer member;
FIG. 3 is a perspective view of a whole superconducting magnet apparatus of FIG. 1;
FIG. 4 is a cross sectional view of a main part of a superconducting magnet apparatus according to a second embodiment of the present invention;
FIG. 5 is a cross sectional view of a main part of a superconducting magnet apparatus according to a third embodiment of the present invention;
FIG. 6 is a perspective view of a whole superconducting magnet apparatus according to a fourth embodiment of the present invention.

Hereinafter, a plurality of embodiments of the present invention will be explained in detail by referring to figures. A same symbol in figures of each of the embodiments indicates an identical object or a corresponding object. It is noted that the present invention can be more effective by combining each of the embodiments as needed.

### (First embodiment)

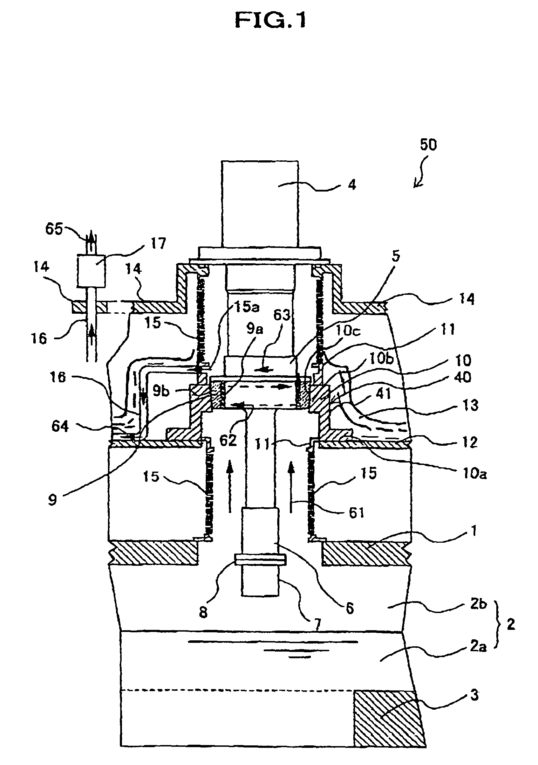

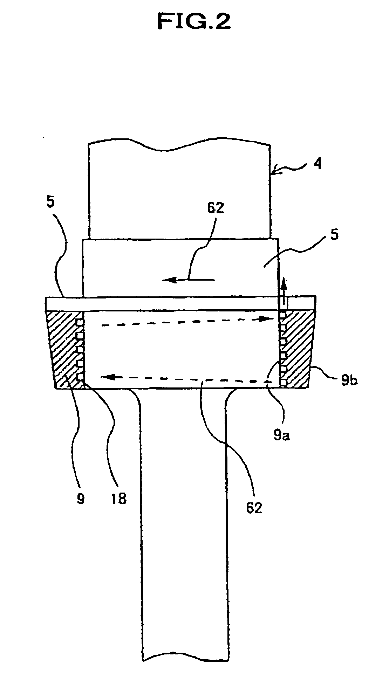

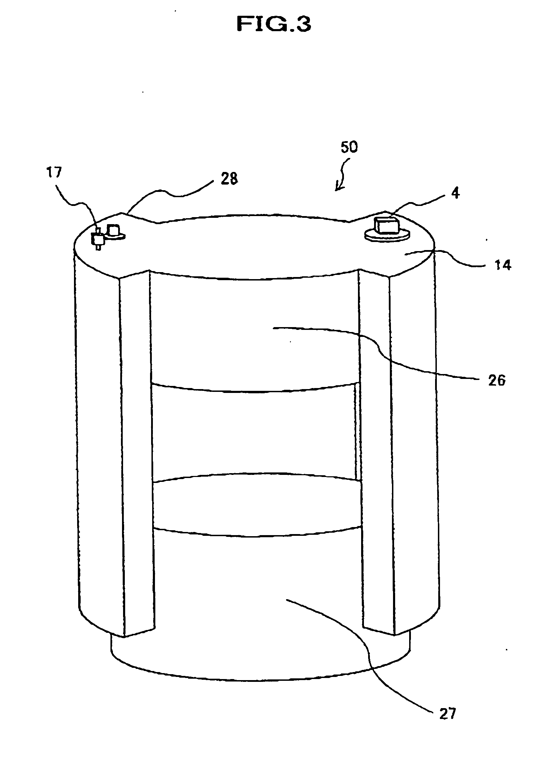

A superconducting magnet apparatus according to a first embodiment of the present invention will be explained by referring to FIG. 1 to FIG. 3. FIG. 1 is a cross sectional view of a main part of the superconducting magnet apparatus according to the first embodiment of the present invention. FIG. 2 is an illustration showing a first stage and a second heat transfer member of FIG. 1. FIG. 3 is a perspective view of a whole superconducting magnet apparatus of FIG. 1. An example of the first embodiment is a superconducting magnet apparatus for MRI (Magnetic Resonance Imaging) which is used for a clinical diagnostic at a medical center.

A superconducting magnet apparatus 50 includes a cryogenic container 1, a thermal shield 12, a vacuum vessel 14, a refrigerator port 40, a refrigerator 4, a heat exchanger 7, a cooling gas pipe 16, and a check valve (one-way valve) 17 as major components.

The cryogenic container 1 accommodates a superconducting coil 3 of MRI and helium 2, which is cryogen for cooling the superconducting coil 3, and is made of stainless steel. The helium 2 is composed of gas-liquid two phases. One is liquid helium 2a which is a liquid cryogen for cooling the superconducting coil 3 by dipping. The other is helium gas 2b as gas cryogen. The helium gas 2b is generated in a part of a free space within the cryogenic container 1 for safety (suppression of over-pressure in the cryogenic container 1). The helium gas 2b is generated due to, for example, evaporation of the liquid helium 2a.

The thermal shield 12 suppresses heat transfer from outside into the cryogenic container 1, and is configured to contain the cryogenic container 1. The thermal shield 12 is cooled down to a temperature between a temperature of the cryogenic container 1 and that of the vacuum vessel 14, and keeps a space between the thermal shield 12 and the cryogenic container 1 in vacuum. An outer periphery of the thermal shield 12 is covered with a laminated heat insulator 13. The laminated heat insulator 13 shields heat radiation from the vacuum vessel 14 at room temperature.

The vacuum vessel 14 suppresses heat transfer from outside into the thermal shield 12 and the cryogenic container 1. The vacuum vessel 14 is made of stainless steel which has a low thermal conductivity and contains the thermal shield 12. The vacuum vessel 14 is arranged to be exposed to air, while keeping a space between the vacuum vessel 14 and the thermal shield 12 in vacuum.

The refrigerator port 40 is a portion for inserting a cooling member of the refrigerator 4 into the vacuum vessel 14, and is configured with a cylindrical member extending to the cryogenic container 1 from the vacuum vessel 14 by passing through the thermal shield 12. One side of the refrigerator port 40 is communicated with an inside of the cryogenic container 1 through an opening of the cryogenic container 1, and the other side is exposed to air through the opening of the vacuum vessel 14. The opening of the vacuum vessel 14 is closed by the refrigerator 4. A space of one side of the refrigerator port 40 is filled with the helium gas 2b. One side end of the refrigerator port 40 is connected to the cryogenic container 1, and the other side end is connected to the vacuum vessel 14.

The refrigerator 4 is configured with a multistage refrigerator and detachably attached to the vacuum vessel 14, with the cooling member of the refrigerator inserted into the refrigerator port 40. The refrigerator 4 includes a first stage 5 which is a cooling member for cooling the thermal shield 12 and a second stage 6 which is a cooling member for cooling the helium 2, and is configured with a two-stage refrigerator in the embodiment. It is preferable that the refrigerator 4 has a refrigerating capability of 60W when the temperature of the first stage 5 is 60K, and 1W when the temperature of the second stage 6 is 4K, respectively, at minimum.

The heat exchanger 7 is arranged in the cryogenic container 1, and thermally connected to the second stage 6 of the refrigerator 4 through an indium foil 8 which has a high thermal conductivity and a high flexibility. With the above configuration, the heat exchanger 7 is cooled down to 4K by the second stage 6. In the figure, the heat exchanger 7 is located in the helium gas 2b. The heat exchanger 7 condenses the helium gas 2b evaporated within the cryogenic container 1 into liquid, and also cools the liquid helium 2a. It is noted that when an end of the heat exchanger 7 is dipped in the liquid helium 2a, the liquid helium 2a is cooled by natural convection.

The cooling gas pipe 16 is a pipe for guiding the helium gas 2b in the refrigerator port 40 to outside the vacuum vessel 14. One end of the cooling gas pipe 16 is communicated with a hole 15a of the refrigerator port 40, and the other end is exposed to outside the vacuum vessel 14. A middle portion of the cooling gas pipe 16 is thermally connected to the thermal shield 12. Therefore, the thermal shield 12 can be cooled by the helium gas 2b which is guided to outside through the cooling gas pipe 16.

The check valve 17 is arranged at an outlet portion of the cooling gas pipe 16 which is located outside the vacuum vessel 14, and opened to release the helium gas 2b when a pressure within the cryogenic container 1 becomes equal to or higher than a predetermined value. That is, when the pressures in the refrigerator port 40 and the cooling gas pipe 16 increase due to increase in the pressure within the cryogenic container 1, and thereby a pressure of the check valve 17 on a side of the refrigerator 40 becomes equal to or a predetermined value higher than the atmospheric pressure, the check valve 17 is automatically opened to release the helium gas 2b in the cryogenic container 1 into the atmosphere through the refrigerator port 40 and the cooling gas pipe 16. When the pressure of the check valve 17 on the side of the refrigerator 40 reaches less than the predetermined value, the check valve 17 is automatically closed to stop release of the helium gas 2b.

In other words, when a refrigerating capability of the refrigerator 4 far exceeds an amount of heat transfer, a pressure inside the cryogenic container 1 becomes a lower pressure than the atmosphere, and as a result, air in the atmospheric could flow back into the cryogenic container 1. To prevent the above back-flow, the check valve 17 is connected at the outlet portion of the helium gas 2b. When the pressure inside the cryogenic container 1 becomes a lower pressure than the atmosphere, the check valve 17 is closed, and as a result, the air in the atmosphere is stopped from flowing. On the other hand, when the pressure inside the cryogenic container 1 is a higher pressure than the atmosphere, the check valve 17 is opened, and as a result, the helium gas 2b in the cryogenic container 1 flows out into the atmosphere.

The aforementioned refrigerator port 40 is composed of a dissimilar joint 41 and a stretchable bellows 15, and both of which are made of different materials. The stretchable bellows 15 is configured to extend in an axial direction of the dissimilar joint 41 from both sides.

The dissimilar joint 41 is configured with a first heat transfer member 10 made of copper or aluminum which has a high thermal conductivity and a low heat transfer member 11 made of stainless steel or the like which has a low thermal conductivity by integrally connecting them. The first heat transfer member 10 has a heat transfer function from a second heat transfer member 9 to the thermal shield 12. Therefore, the first heat transfer member 10 is made of a high thermal conductive material.

The bellows 15 is made of stainless steel or the like which has a low thermal conductivity and configured to connect between the first heat transfer member 10 and the cryogenic container 1, and between the first heat transfer member 10 and the vacuum vessel 14, together with a low heat transfer member 11. This bellows 15 and the low heat transfer member 11 are required to have a small thermal conduction between the first heat transfer member 10 and the cryogenic container 1 and between the first heat transfer member 10 and the vacuum vessel 14. Therefore, they are made of a low thermal conductive material.

Since both ends of the dissimilar joint 41 are made of stainless steel, TIG welding can be used for connecting the dissimilar joint 41 with the vacuum vessel 14, and the dissimilar joint 41 with the cryogenic container 1. It is noted that, in the embodiment, since the first stage 5 is located apart from the vacuum vessel 14 and the cryogenic container 1, the bellows 15 made of stainless steel is connected between the dissimilar joint 41 and the vacuum vessel 14, and between the dissimilar joint 41 and the cryogenic container 1. Instead of the bellows 15, a pipe made of stainless steel may be connected.

The first heat transfer member 10 has a flange portion 10a protruding outward from a lower end of the first heat transfer member 10 on a thermal shield 12 side. The flange portion 10a is thermally connected to the thermal shield 12. In addition, the first heat transfer member 10 has a flange portion 10b protruding inside from an upper end of the first heat transfer member 10 on a first stage 5 side. An inner perimeter face of the flange portion 10b is formed in concave-tapered surface (a tapered surface which has a diameter becoming larger from a bottom to a top of the tapered surface) 10c. The low heat transfer member 11 connects both sides of the first heat transfer member 10 and the bellows 15. The bellows 15 is configured to be stretchable so that the concave-tapered surface 10c and a convex-tapered surface (a tapered surface which has a diameter becoming larger from a bottom to a top of the tapered surface) 9b are closely contacted even when a thermal shrinkage is caused due to cooling of the refrigerator 4. It is noted that a spring may be arranged between the dissimilar joint 41 and the vacuum vessel 14 for giving a resilient force.

As shown in FIG. 1 and FIG. 2, the second heat transfer member 9, which is made of a high thermal conductive material, is thermally connected to the first stage 5 of the refrigerator 4. The second heat transfer member 9 is thermally connected and detachably jointed to the first heat transfer member 10. With the above configuration, when the refrigerator 4 is in trouble, the refrigerator 4 can be repaired by detaching thereof.

Practically, the above joint is achieved as follows. The convex-tapered surface 9b which is a tapered surface fitting to a tapered surface of the concave-tapered surface 10c is formed on the outer perimeter face of the second heat transfer member 9. Then, the convex-tapered surface 9b of the second heat transfer member 9 is fitted to the concave-tapered surface 10c of the first heat transfer member 10. With the configuration, it becomes possible to provide an increase in a heat transfer area and an excellent thermal contact between the concave-tapered surface 10c and the convex-tapered surface 9b, while making attachment and detachment of the refrigerator 4 easy. Since the helium gas 2b, which has a high thermal conductivity, exists between the concave-tapered surface 10c and the convex-tapered surface 9b, and since a gap between them is extremely small, a constant thermal resistance is obtained regardless of a contact pressure if the concave-tapered surface 10c is in contact with the convex-tapered surface 9b. Therefore, it is possible to decrease a thermal resistance between the second heat transfer member 9 and the first heat transfer member 10 equal to or less than 0.1K/W. Accordingly, a stable cooling performance can be obtained regardless of a number of the attachments and detachments.

It is noted that a space within the refrigerator port 40 is divided into two spaces by fitting of the second heat transfer member 9 and the first heat transfer member 10. As a result, a flow of the helium gas 2b from one space to the other can be formed by a gas flow path 18, which will be described later.

The gas flow path 18 is formed on an attachment surface of the second heat transfer member 9 against the first stage 5. When the refrigerator 4 is stopped, the gas flow path 18 guides the helium gas 2b, which is evaporated within the cryogenic container 1, from one space (bottom side in FIG. 1) of the refrigerator port 40 for cooling the second heat transfer member 9 and the first stage 5, and after that, guides the helium gas 2b to the other space (upper side in FIG. 1). The gas flow path 18 is formed in a spiral groove so that it winds around an outer perimeter face of the first stage 5.

All of the first heat transfer member 10, the low heat transfer member 11, the bellows 15, the second heat transfer member 9, the first stage 5, and the second stage 6 are formed in a cylindrical shape and arranged in a concentric fashion.

As shown in FIG. 3, the superconducting magnet apparatus 50 is configured such that the vacuum vessel 14 is divided into an upper vacuum vessel 26 and a lower vacuum vessel 27. A patient enters in a space between the vacuum vessels 26, 27. With the above configuration, the patient can be relaxed because of less cooped-up feeling when the patient enters in the space. Meanwhile, a symbol 28 is a service port for supplying power to a portion of the liquid helium 2a and the superconducting coil 3.

In normal operation of the refrigerator 4, the thermal shield 12 and the heat exchanger 7 are cooled by the cooled first stage 5 and the cooled second stage 6, respectively. Therefore, the heat exchanger 7 is cooled down to a temperature at about 4K, as well as the thermal shield 12 is cooled down to a temperature equal to or less than 60K. As a result, the helium gas 2b condenses into liquid on a surface of the heat exchanger 7. Accordingly, the superconducting magnet apparatus can be operated stably without consuming liquid helium when the apparatus is in operation.

When the refrigerator 4 is stopped by an electric power outage or the like, the first stage 5 and the second stage 6 of the refrigerator 4 lose a cooling capability, and a temperature of the thermal shield 12 increases. As a result, radiation heat from the cryogenic container 1 and conductive heat from, for example, a load support which connects the thermal shield 12 and the cryogenic container 1 increase. In addition, heat transfer into the cryogenic container 1 increases by conductive heat from the vacuum vessel 14 to the first stage 5 of the refrigerator 4 and from the first stage 5 to the second stage 6. Accordingly, a pressure within the cryogenic container 1 is increased, and the check valve 17 is opened. As a result, cool helium gas 2b at 4K, which is evaporated and pooled in an upper portion of the cryogenic container 1, flows in a direction indicated by arrows, 61, 62, 63, 64 in FIG. 1 and FIG. 2 and released into the atmosphere.

That is, the helium gas 2b evaporated and pooled in the upper portion of the cryogenic container 1 enters into one space of the refrigerator port 40, flows in a direction indicated by an arrow 61, cools the second stage 6 with sensible heat, and after that, flows into the gas flow path 18. As shown by an arrow 62, the helium gas 2b flown into the gas flow path 18 flows in a groove formed spirally, heat-exchanges with the second heat transfer member 9, which is a high thermal conductive material, through a wide contact area, and cools the second heat transfer member 9 with the sensible heat. The first heat transfer member 10 which is in contact with the second heat transfer member 9 is also cooled by thermal conduction and their contact. Since the cooled first heat transfer member 10 is thermally connected to the thermal shield 12, the thermal shield 12 is also cooled. As a result, a function (that is, a function to suppress heat transfer from outside into the cryogenic container 1) of the thermal shield 12 is maintained

The helium gas 2b which passes through the gas flow path 18 enters into the other space of the refrigerator port 40, flows in a direction as indicated by an arrow 63, and flows into the cooling gas pipe 16 through a hole 15a of the refrigerator port 40. Since the cooling gas pipe 16 is thermally connected to the thermal shield 12, the thermal shield 12 is also cooled by the sensible heat of the helium gas 2b while flowing in the cooling gas pipe 16 in a direction as indicated by an arrow 64. Meanwhile, a gas temperature of the helium 2 at the liquid interface is 4.5 K. Since a temperature of the thermal shield 12, which is in a range of between 40K and 60K, is higher than the gas temperature, a cooling amount of heat by the sensible heat is large. Then, the helium gas 2b passed through the cooling gas pipe 16 is released into the atmosphere as indicated by an arrow 65 through the check valve 7.

As described above, since the first stage 5 and the second stage 6, which are cooling members of the refrigerator 4, and the thermal shield 12 are cooled when the refrigerator 4 is stopped, an amount of heat transfer into the liquid helium 2a can be prevented from increasing. As a result, it becomes possible to maintain the superconducting coil 3, which is a cooling object (object to be cooled), in a cooled condition for a long time, while reducing an amount of consumption of the liquid helium 2a. Accordingly, the superconducting magnet apparatus for MRI can be operated without quenching for a long time when the refrigerator 4 is stopped.

It is noted that viscosity of the helium gas 2b becomes small as the temperature decreases, a density of the helium gas 2b becomes large as the temperature decreases, and a dynamic coefficient of viscosity of the helium gas 2b becomes small as the temperature decreases. Therefore, a pressure loss becomes small as the temperature decreases if the shape in which the helium gas 2b flows is identical. It is dispensable to make a cross section of the flow path small and to make the flow path long for obtaining a wide heat transfer area if the temperature is equal to or less than 10K. Therefore, since a cooling performance of the gas flow path 18, which has a narrow flow path, can be increased, the gas flow path 18 has effects to decrease a temperature of the first stage 5 of the refrigerator 4. In addition, an amount of heat transfer into the second stage 6 depends on a temperature of the first stage 5. For maintaining a temperature of the second stage 6, which is close to a liquid surface of the liquid helium 2a, at a low temperature, it is effective to decrease the temperature of the first stage 5. This also has an advantage to reduce heat transfer into the liquid helium 2a from the second stage 6.

### (Second embodiment)

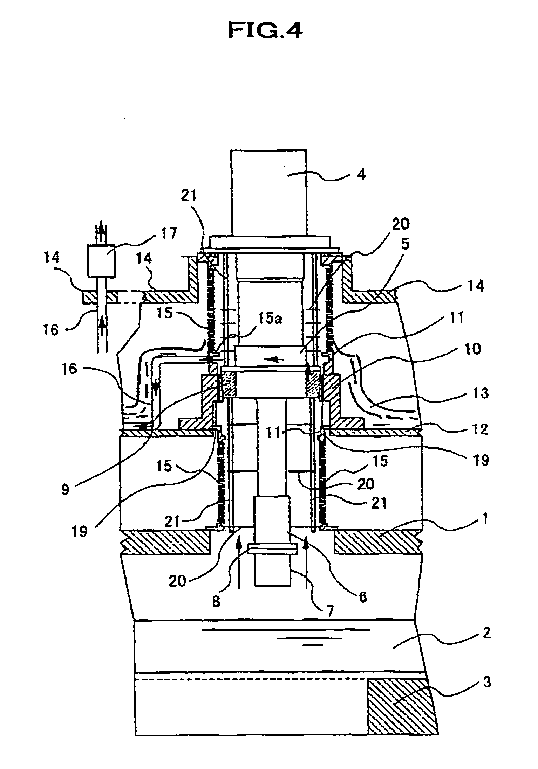

Next, a superconducting magnet apparatus according to a second embodiment of the present invention will be explained by referring to FIG. 4. FIG. 4 is a cross sectional view of a main part of the superconducting magnet apparatus according to the second embodiment. The second embodiment is identical to the first embodiment except the following points to be described later. Therefore, a duplicate explanation will be omitted with respect to the identical part.

In the second embodiment, a gas flow path 19 is disposed in the first heat transfer member 10. This is different from the first embodiment in which the gas flow path 18 is disposed in the second heat transfer member 9. In addition, the gas flow path 19 is formed by straight, narrow, and many (this is different from the first embodiment) circular holes.

According to the second embodiment, since the gas flow path 19 cools the thermal shield 12 and the first stage 5, and also the helium gas 2b directly cools the first heat transfer member 10, it is effective to preferentially cool the thermal shield 12.

In addition, in the second embodiment, a shield plate 20 for shielding radiation heat and a supporting rod 21 for supporting and fixing the shield plate 20 are arranged in respective spaces within the refrigerator port 40. With this configuration, heat transfer by radiation through the refrigerator port 40 can be reduced, especially the heat transfer can be effectively reduced when the refrigerator 4 is stopped. It is noted that the supporting rod 21 on one side of the refrigerator port 40 is fixed by utilizing the second heat transfer member 9.

### (Third embodiment)

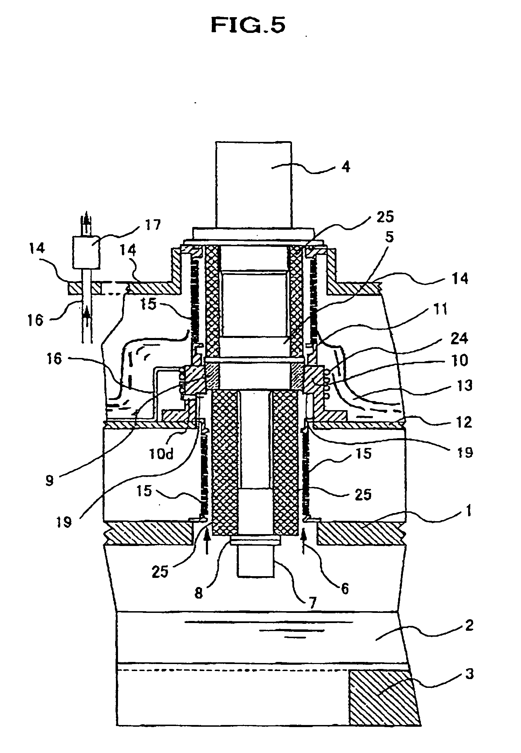

Next, a superconducting magnet apparatus according to a third embodiment of the present invention will be explained by referring to FIG. 5. FIG. 5 is a cross sectional view of a main part of the superconducting magnet apparatus according to the third embodiment. The third embodiment is basically identical to the first embodiment except the following points to be described later. Therefore, a duplicate explanation will be omitted with respect to an identical part.

In the third embodiment, a gas flow path 24, which is made of a high thermal conductive pipe, is disposed on an external surface of the first heat transfer member 10. One side of the gas flow path 24 is communicated with a hole 10d passing through the first heat transfer member 10 and the other side is directly communicated with the cooling gas pipe 16. The hole 10d is opened to one space of the refrigerator port 40.

According to the third embodiment, the gas flow path 24 has a function to cool the thermal shield 12 and the first stage 5, and the helium gas 2b cools the thermal shield 12 through the first heat transfer member 10 by directly cooling the first heat transfer member 10. In addition, the thermal shield 12 is cooled by directly guiding the helium gas 2b into the cooling gas pipe 16 from the gas flow path 24. Accordingly, the embodiment is effective for preferentially cooling the thermal shield 12.

Further, in the third embodiment, a porous polymer 25 is arranged in a space between the atmosphere at room temperature and the first stage 5, and on the periphery outside the refrigerator 4 filled with the helium gas 2b. The porous polymer 25 is also arranged between the first stage 5 and the second stage 6. The porous polymer 25 is a polymer material and has a lower thermal conductivity compared with a usual polymer. The porous polymer 25 is effective to suppress convection of the helium gas 2b. Therefore, an amount of heat transfer by the convection can be reduced. In addition, since the porous polymer 25 arranged between the first stage 5 and the second stage 6 makes a flow path cross section small within the refrigerator port 40, a flow rate of the helium gas 2b can be increased when the refrigerator 4 is stopped. Therefore, the helium gas 2b can improve heat-exchange with the bellows 15 and the porous polymer 25 between the second stage 6 and the first stage 5. As a result, temperatures of the bellows 15 and the porous polymer 25 can be decreased. Accordingly, the amount of heat transfer can be further reduced.

### (Fourth embodiment)

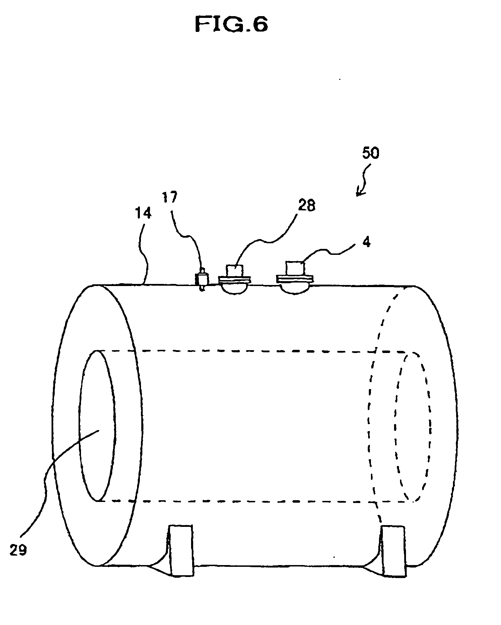

Next, a superconducting magnet apparatus according to a fourth embodiment of the present invention will be explained by referring to FIG. 6. FIG. 6 is a perspective view of a whole superconducting magnet apparatus according to the fourth embodiment. The fourth embodiment is identical to the first embodiment except the following points described later. Therefore, a duplicate explanation will be omitted with respect to an identical part.

A superconducting magnet apparatus 50 according to the fourth embodiment is a superconducting magnet apparatus for MRI in which a cylinder-shaped superconducting coil is placed horizontally, and configured so that a patient can enter in a horizontal hollow circular cylinder. In this case, a direction of the superconducting coil is different from those of the aforementioned embodiments. However, a cooling configuration around the first stage 5 of the refrigerator 4 can be made identical to the aforementioned embodiments. Therefore, the cooling configuration according to the fourth embodiment can apply to a double-decker type superconducting magnet apparatus for MRI in which two cylinder-shaped superconducting coils, top and bottom, are arranged, and to a superconducting magnet apparatus for MRI in which the cylinder-shaped superconducting coil is placed horizontally.

## Claims

1. A superconducting magnet apparatus (50), comprising:
a cryogenic container (1) containing a superconducting coil (3) and helium (2) for cooling the superconducting coil (3);
a thermal shield (12) containing the cryogenic container (1);
a vacuum vessel (14) containing the thermal shield (12);
a refrigerator port (40) which reaches the cryogenic container (1) from the vacuum vessel (14) by passing through the thermal shield (12); and
a multistage refrigerator (4) which is detachably attached within the refrigerator port (40) and has a first stage (5) for cooling the thermal shield (12) and a second stage (6) for cooling the helium (2),
**characterised in that**:
the refrigerator port (40) has a first heat transfer member (10) which is made of copper or aluminium and is thermally connected to the thermal shield (12);
a low heat transfer member (11) connects the first heat transfer member (10) and the vacuum vessel (14), the low heat transfer member (11) being made of stainless steel which has a low thermal conductivity;
a second heat transfer member (9) made of a material having a high thermal conductivity is thermally connected and attached to the first stage (5) of the multistage refrigerator (4) and detachably attached to the first heat transfer member (10); and
a gas flow path (16,18) is formed at a surface of the first heat transfer member (10) or the second heat transfer member (9) and is capable of providing fluid communication between the cryogenic container (1) and an exterior of the vacuum vessel (14) via the refrigerator port (40) when an operation of the multistage refrigerator is stopped, whereby evaporated helium gas within the cryogenic container (1) is released to the exterior of the vacuum vessel (14) via the gas flow path (16,18) after flowing within the refrigerator port (40) and over the surface of one of the first heat transfer member (10) and the second heat transfer member (9) to exchange heat with that heat transfer member when an operation of the multistage refrigerator is stopped.

2. The superconducting magnet apparatus according to claim 1,
wherein a first tapered surface (10c) which has a diameter becoming larger from a bottom to a top of the first tapered surface is formed on an inner periphery surface of the first heat transfer member (10), and a second tapered surface (96) which has a diameter becoming larger from a bottom to a top of the second tapered surface is formed on an outer periphery surface of the second heat transfer member (9),
wherein the second heat transfer member (9) is detachably attached to the first heat transfer member (10) by fitting the second tapered surface (96) to the first tapered surface (10c).

3. The superconducting magnet apparatus according to claim 1 or 2,
wherein the gas flow path (18) is formed on a surface of the second heat transfer member (9) which forms an interface with the first stage (5) of the multistage refrigerator.

4. The superconducting magnet apparatus according to claim 3,
wherein the gas flow path (18) is a groove formed spirally which winds an outer periphery surface of the first stage (5).

5. The superconducting magnet apparatus according to claim 1 or 2,
wherein the gas flow path passes through an inside of one of the first heat transfer member (10) and the second heat transfer member (9).

6. The superconducting magnet apparatus according to claim 1 or 2,
wherein the gas flow path (18) is formed in a spiral shape which winds an outer periphery surface of the second heat transfer member (9).

7. The superconducting magnet apparatus according to claim 3,
wherein the helium gas that passed through the gas flow path is released to the exterior of the vacuum vessel through a check valve (17) after heat-exchanging with the thermal shield and passing through the vacuum vessel.

8. The superconducting magnet apparatus according to claim 1,
wherein a porous polymer wall (25) is disposed in a space formed between the multistage refrigerator (4) and the refrigerator port (40).

9. The superconducting magnet apparatus according to claim 1,
wherein the superconducting coil is a superconducting coil for MRI; and
wherein the helium contained in the cryogenic container is composed of gas-liquid two phases of helium gas and liquid helium, and the superconducting coil for MRI is dipped in the liquid helium.

## Patentansprüche

1. Supraleitendes Magnetgerät (50), das aufweist:
einen kryogenen Behälter (1), der eine supraleitende Spule (3) und Helium (2) zum Kühlen der supraleitenden Spule (3) enthält;
eine Wärmeabschirmung (12), die den kryogenen Behälter (1) enthält;
ein Vakuumgefäß (14), das die Wärmeabschirmung (12) enthält;
einen Kühlanlagenanschluss (40), der vom Vakuumgefäß (14) aus den kryogenen Behälter (1) erreicht, indem er die Wärmeabschirmung (12) durchtritt; und
eine mehrstufige Kühlanlage (4), die lösbar innerhalb des Kühlanlagenanschlusses (40) angeschlossen ist und eine erste Stufe (5) zum Kühlen der Wärmeabschirmung (12) und eine zweite Stufe (6) zum Kühlen des Heliums (2) aufweist,
**dadurch gekennzeichnet, dass:**
der Kühlanlagenanschluss (40) ein erstes Wärmeübertragungsteil (10) aus Kupfer oder Aluminium aufweist, das thermisch mit der Wärmeabschirmung (12) verbunden ist;
das erste Wärmeübertragungsteil (10) und das Vakuumgefäß (14) durch ein gering Wärme übertragendes Teil (11) aus Edelstahl verbunden ist, der eine niedrige Wärmeleitfähigkeit aufweist;
mit der ersten Stufe (5) der mehrstufigen Kühlanlage (4) ein zweites Wärmeübertragungsteil (9) aus einem Material, das eine hohe Wärmeleitfähigkeit aufweist, thermisch verbunden und daran befestigt ist und lösbar an dem ersten Wärmeübertragungsteil (10) befestigt ist; und
an einer Oberfläche des ersten Wärmeübertragungsteils (10) oder des zweiten Wärmeübertragungsteils (9) ein Gasströmungspfad (16, 18) ausgebildet ist, der zum Bereitstellen einer Fluidverbindung zwischen dem kryogenen Behälter (1) und einem Äußeren des Vakuumgefäßes (14) über den Kühlanlagenanschluss (40) geeignet ist, wenn der Betrieb der mehrstufigen Kühlanlage gestoppt wird, wobei verdampftes Heliumgas innerhalb des kryogenen Behälters (1) über den Gasströmungspfad (16, 18) zum Äußeren des Vakuumgefäßes (14) freigegeben wird, nachdem es innerhalb des Kühlanlagenanschlusses (40) und über die Oberfläche des ersten Wärmeübertragungsteils (10) oder des zweiten Wärmeübertragungsteils (9) geströmt ist, um Wärme mit dem Wärmeübertragungsteil auszutauschen, wenn ein Betrieb der mehrstufigen Kühlanlage gestoppt wird.

2. Supraleitendes Magnetgerät nach Anspruch 1,
wobei an einer Innenumfangsfläche des ersten Wärmeübertragungsteils (10) eine erste abgeschrägte Fläche (10c) ausgebildet ist, die einen von ihrem Boden zu ihrer Oberkante größer werdenden Durchmesser aufweist, und an einer Außenumfangsfläche des zweiten Wärmeübertragungsteils (9) eine zweite abgeschrägte Fläche (9b) ausgebildet ist, die einen von ihrem Boden zu ihrer Oberkante größer werdenden Durchmesser aufweist,
wobei das zweite Wärmeübertragungsteil (9) lösbar an dem ersten Wärmeübertragungsteil (10) befestigt ist, indem die zweite abgeschrägte Fläche (9b) an die erste abgeschrägte Fläche (10c) angesetzt ist.

3. Supraleitendes Magnetgerät nach Anspruch 1 oder 2,
wobei der Gasströmungspfad (18) an einer Fläche des zweiten Wärmeübertragungsteils (9) ausgebildet ist, das eine Schnittstelle mit der ersten Stufe (5) der mehrstufigen Kühlanlage bildet.

4. Supraleitendes Magnetgerät nach Anspruch 3,
wobei der Gasströmungspfad (18) eine spiralförmig ausgebildete Rinne ist, die sich um eine Außenumfangsfläche der ersten Stufe (5) windet.

5. Supraleitendes Magnetgerät nach Anspruch 1 oder 2,
wobei der Gasströmungspfad durch das Innere des ersten Wärmeübertragungsteils (10) oder des zweiten Wärmeübertragungsteils (9) tritt.

6. Supraleitendes Magnetgerät nach Anspruch 1 oder 2,
wobei der Gasströmungspfad (18) in einer Spiralform ausgebildet ist, die sich um eine Außenumfangsfläche des zweiten Wärmeübertragungsteils (9) windet.

7. Supraleitendes Magnetgerät nach Anspruch 3,
wobei das den Gasströmungspfad durchtretende Heliumgas nach dem Wärmeaustausch mit der Wärmeabschirmung und Durchtreten des Vakuumgefäßes durch ein Rückschlagventil (17) zum Äußeren des Vakuumgefäßes freigegeben wird.

8. Supraleitendes Magnetgerät nach Anspruch 1,
wobei in einem zwischen der mehrstufigen Kühlanlage (4) und dem Kühlanlagenanschluss (40) gebildeten Raum eine poröse Polymerwand (25) angeordnet ist.

9. Supraleitendes Magnetgerät nach Anspruch 1,
wobei die supraleitende Spule eine supraleitende Spule zur Magnetresonanzabbildung ist; und
wobei das in dem kryogenen Behälter enthaltene Helium aus einer zweiphasigen Gas-Flüssigkeit aus Heliumgas und flüssigem Helium zusammengesetzt ist und die supraleitende Spule zur Magnetresonanzabbildung in das flüssige Helium getaucht ist.

## Revendications

1. Appareil à aimant supraconducteur (50), comprenant:
un contenant cryogénique (1) contenant une bobine supraconductrice (3) et de l'hélium (2) pour le refroidissement de la bobine supraconductrice (3);
une protection thermique (12) contenant le contenant cryogénique (1);
une cuve à vide (14) contenant la protection thermique (12);
un orifice de réfrigérateur (40) qui atteint le contenant cryogénique (1) depuis la cuve à vide (14) en passant à travers la protection thermique (12); et
un réfrigérateur multi-étage (4) qui est fixé amoviblement dans l'orifice de réfrigérateur (40) et qui possède un premier étage (5) pour le refroidissement de la protection thermique (12) et un deuxième étage (6) pour le refroidissement de l'hélium (2),
**caractérisé en ce que:**
l'orifice de réfrigérateur (40) possède un premier élément de transfert de chaleur (10) qui est réalisé en cuivre ou aluminium, et est relié thermiquement à la protection thermique (12);
un élément de transfert de chaleur bas (11) relie le premier élément de transfert de chaleur (10) et la cuve à vide (14), l'élément de transfert de chaleur bas (11) étant réalisé en acier inoxydable qui possède une faible conductivité thermique;
un deuxième élément de transfert de chaleur (9) réalisé en un matériau d'une conductivité thermique élevée est reliée thermiquement et fixée au premier étage (5) du réfrigérateur multi-étage (4) et est fixé amoviblement au premier élément de transfert de chaleur (10); et
un chemin d'écoulement de gaz (16, 18) est formé à une surface du premier élément de transfert de chaleur (10) ou du deuxième élément de transfert de chaleur (9) et est apte à établir une communication fluidique entre le contenant cryogénique (1) et un extérieur de la cuve à vide (14) par l'orifice de réfrigérateur (40) lorsque l'opération de réfrigérateur multi-étage est arrêtée, par quoi le gaz d'hélium évaporé dans le contenant cryogénique (1) est libéré à l'extérieur de la cuve à vide (14) par le chemin d'écoulement de gaz (16, 18) après l'écoulement dans l'orifice de réfrigérateur (40) et sur la surface d'un parmi le premier élément de transfert de chaleur (10) et le deuxième élément de transfert de chaleur (9) pour échanger la chaleur avec cet élément de transfert de chaleur lorsqu'une opération du réfrigérateur multi-étage est arrêtée.

2. Appareil à aimant supraconducteur selon la revendication 1, dans lequel une première surface conique (10c) qui a un diamètre qui devient plus large du fond au sommet de la première surface conique est formée sur une surface de périphérie intérieure du premier élément de transfert de chaleur (10), et une deuxième surface conique (96) qui a un diamètre devenant plus large du fond au sommet de la deuxième surface conique est formée sur une surface de périphérie extérieure du deuxième élément de transfert de chaleur (9),
où le deuxième élément de transfert de chaleur (9) est fixé amoviblement au premier élément de transfert de chaleur (10) en montant la deuxième surface conique (96) sur la première surface conique (10c).

3. Appareil à aimant supraconducteur selon la revendication 1 ou 2, dans lequel le chemin d'écoulement de gaz (18) est formé sur une surface du deuxième élément de transfert de chaleur (9) qui forme une interface avec le premier étage (5) du réfrigérateur multi-étage.

4. Appareil à aimant supraconducteur selon la revendication 3, dans lequel le chemin d'écoulement de gaz (18) est une rainure réalisée en spirale qui s'enroule sur une surface périphérique extérieure du premier étage (5).

5. Appareil à aimant supraconducteur selon la revendication 1 ou 2, dans lequel le chemin d'écoulement de gaz passe à travers un intérieur d'un parmi le premier élément de transfert de chaleur (10) et le deuxième élément de transfert de chaleur (9).

6. Appareil à aimant supraconducteur selon la revendication 1 ou 2, dans lequel le chemin d'écoulement de gaz (18) est réalisé en une forme de spirale qui s'enroule sur une surface périphérique extérieure du deuxième élément de transfert de chaleur (9).

7. Appareil à aimant supraconducteur selon la revendication 3, dans lequel le gaz d'hélium qui a traversé le chemin d'écoulement de gaz est libéré vers l'extérieur de la cuve à vide à travers une vanne de retenue (17) après l'échange de chaleur avec la protection thermique et passant à travers la cuve à vide.

8. Appareil à aimant supraconducteur selon la revendication 1, dans lequel une paroi poreuse en polymère (25) est disposée dans un espace formé entre le réfrigérateur multi-étage (4) et l'orifice de réfrigérateur (40).

9. Appareil à aimant supraconducteur selon la revendication 1, dans lequel la bobine supraconductrice est une bobine supraconductrice pour IRM; et
dans lequel l'hélium se trouvant dans le contenant cryogénique est constitué de deux phases gaz-liquide de gaz d'hélium et d'hélium liquide, et la bobine supraconductrice pour l'IRM est trempée dans l'hélium liquide.
